# EUROPEAN PATENT SPECIFICATION

(11) **EP 0 921 715 B1**
(45) Date of publication and mention of the grant of the patent: **06.09.2006**
(21) Application number: 98309118.2
(22) Date of filing: 06.11.1998
(51) Int. Cl.: H05K 1/02, H05K 1/18

(54) **PCB for mounting an RF band-pass filter and method of manufacture thereof**
Leiterplatte zur Montage eines RF-Bandpassfilters und Verfahren zu deren Herstellung
Panneau à circuit imprimé pour un filtre passe-bande RF et son procédé de fabrication

(30) Priority: 06.11.1997 KR 9758419
(43) Date of publication of application: 09.06.1999
(73) Proprietor: SAMSUNG ELECTRONICS CO., LTD., Suwon-City, Kyungki-do (KR)
(72) Inventor: Kim, Ju-Nyun, Paldal-gu, Suwon-shi, Kyyungki-do (KR)
(74) Representative: Boakes, Jason Carrington

(56) References cited:
- WO-A-92/03033
- PATENT ABSTRACTS OF JAPAN vol. 15, no. 74 (E-1036), 21 February 1991 & JP 02 295183 A (MATSUSHITA ELECTRIC WORKS), 6 December 1990
- PATENT ABSTRACTS OF JAPAN vol. 95, no. 11, 26 December 1995 & JP 07 221510 A (ADVANTEST CORP.), 18 August 1995
- PATENT ABSTRACTS OF JAPAN vol. 14, no. 36 (E-877), 23 January 1990 & JP 01 270289 A (MATSUSHITA ELECTRIC IND CO), 27 October 1989
- PATENT ABSTRACTS OF JAPAN vol. 17, no. 110 (E-1329), 8 March 1993 & JP 04 294602 A (NEC CORP), 19 October 1992
- PATENT ABSTRACTS OF JAPAN vol. 95, no. 9, 31 October 1995 & JP 07 162212 A (MURATA MFG CO), 23 June 1995
- PATENT ABSTRACTS OF JAPAN vol. 96, no. 1, 31 January 1995 & JP 07 240659 A (MITSUMI ELECTRIC CO), 12 September 1995

## Description

The present invention relates to a PCB (Printed Circuit Board) for mounting an RF (Radio Frequency) BPF (Band Pass Filter) and a method of making the same. In particular, the invention relates to a PCB so designed that a BPF being a dielectric filter can be mounted on the PCB with minimal change in filter characteristics, and a method of making such a PCB.

The elements of a radio communications system are typically mounted on a PCB. For example, an RF BPF is separately procured and is mounted on a PCB, with other components, during manufacture of the radio communications system.

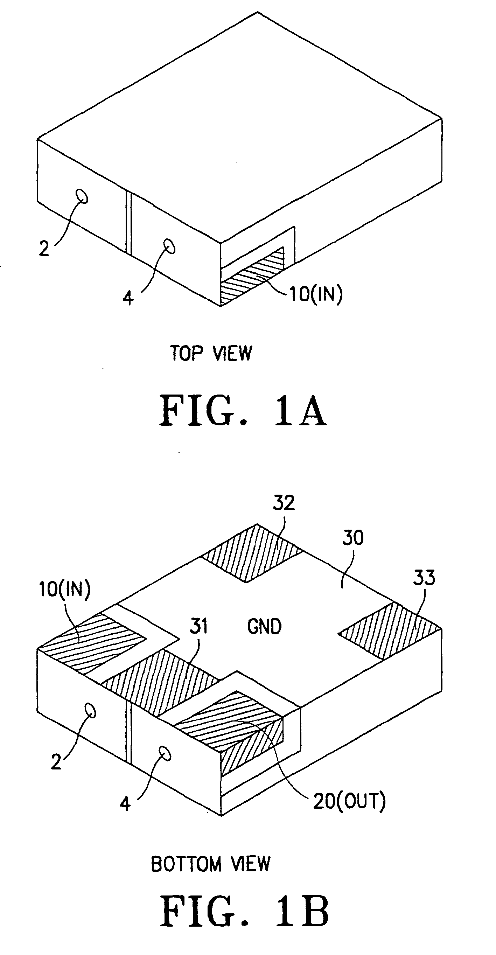

FIGs. 1A and 1B are perspective views, respectively of the top and bottom of an RF BPF in respect of which the present invention may be applied. As an example, the RF BPF shown and considered in the following description is a dielectric filter.

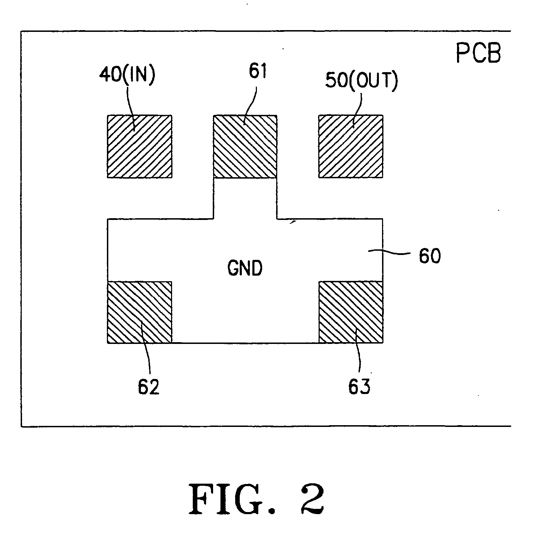

During manufacture of a radio communications system, the RF BPF is typically mounted by soldering onto a PCB such as that shown in plan view in FIG. 2. A PCB is typically constructed from a non-conductive sheet, carrying conductive regions in selected locations. The conductive regions are separated by non-conductive regions, typically composed of exposed regions of the non-conductive sheet.

The RF BPF shown in FIGs. 1A, 1B includes an input terminal (IN) 10, an output terminal (OUT) 20, and three ground (GND) terminals 31, 32, 33. The ground terminals 31, 32, 33 of the BPF may be connected together by a planar ground conductor 30 located on the surface of the BPF.

The terminals of the BPF are respectively soldered onto an IN pad 40, an OUT pad 50, and three ground (GND) pads 61, 62, 63 of the PCB, thereby mounting the RF BPF onto the PCB. 'Mounting' the BPF on the PCB includes electrically connecting the BPF. Mechanical support to the BPF may be provided by means of the soldered terminals, or by other means, such as a mechanical clamp.

Each pad consists of a conductive region of the PCB, separated from other pads by a non-conductive region, such as a region of the non-conductive sheet of the PCB. The three ground pads 61, 62, 63 of the PCB may be connected together by a ground conductor 60, formed as a conductive region of the PCB.

When the RF BPF as shown in FIGs. 1A and 1B is mounted on the PCB of FIG. 2 as described, a parasitic capacitance components exists between IN terminal/pad 10/40 and both an adjacent ground terminal/pad 31/61 and adjacent regions of ground conductors 30, 60. A similar parasitic capacitance component exists between OUT terminal/pad 20/50 and both an adjacent ground terminal/pad 31/61 and adjacent regions of ground conductor 30, 60. These parasitic capacitances change the characteristics of the BPF.

Despite designing the BPF to satisfy BPF specified characteristic requirements, the BPF cannot reliably operate according to those specified requirements when mounted on the PCB. This is due to the effects of the parasitic capacitances, which effects may include increased losses and changed centre frequency.

FIG. 3 is a Smith chart showing RF BPF characteristics of an unmounted RF BPF, which meets specified requirements. The impedance is at an inductance location as indicated by curve "A" and frequency bandwidth is wide as indicated by curve "B" in FIG. 3.

FIG. 4 is a Smith chart showing characteristics of an RF BPF such as that of FIG. 3, but mounted on a PCB. The mounted RF BPF no longer meets the specified requirements. The impedance is changed to have more capacitance components as indicated by curve "A" and the frequency bandwidth becomes narrow as indicated by curve "B".

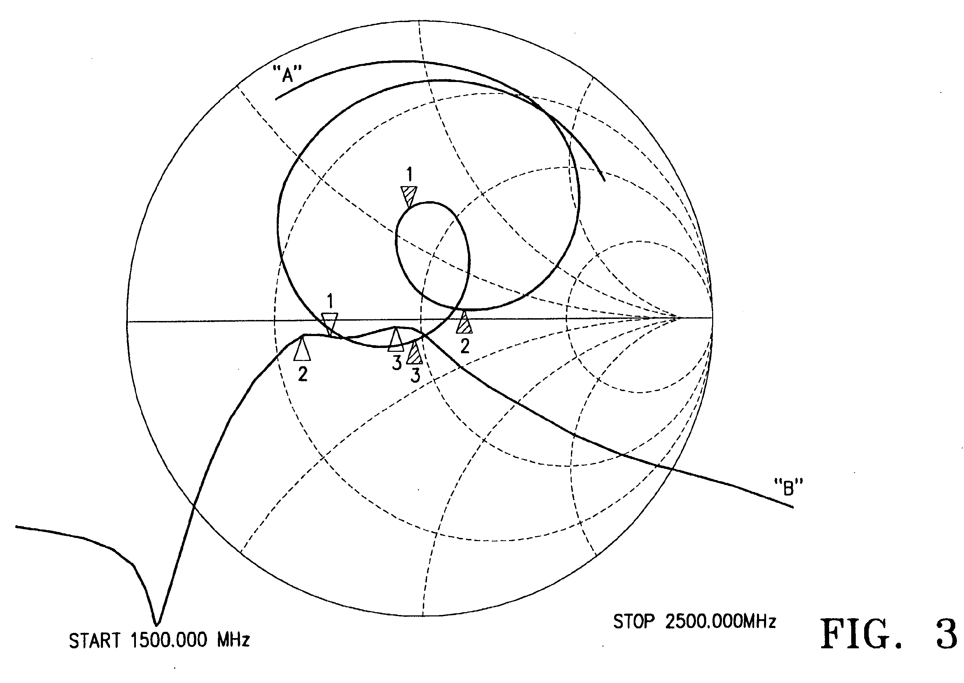

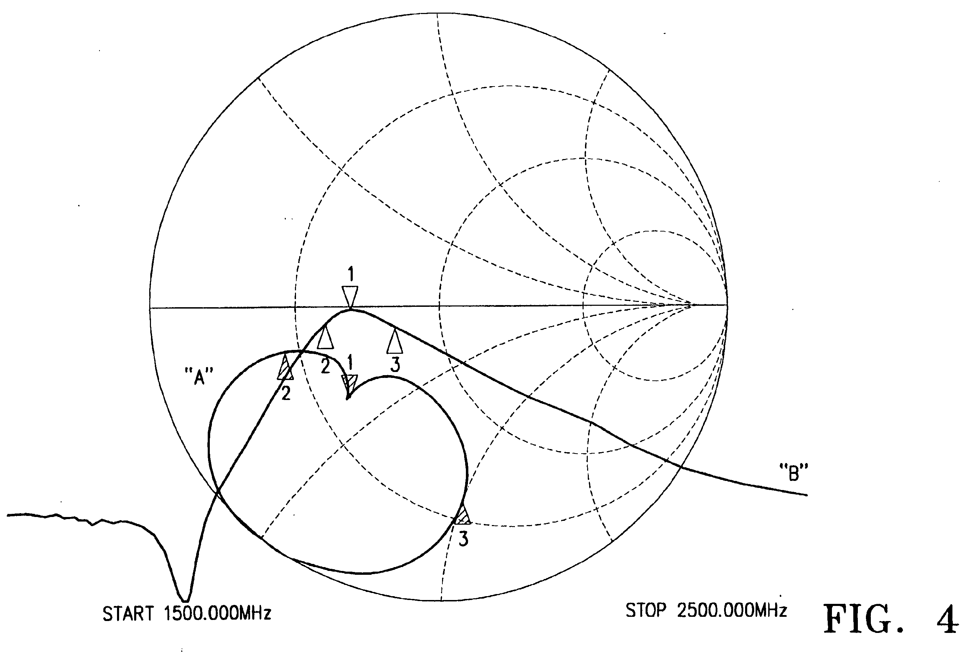

While it is desired that the RF BPF shows the characteristics of FIG. 3 even when mounted on the PCB, the characteristics of the RF BPF actually change when it is mounted on the PCB, as shown in FIG. 4. This change is attributed to the parasitic capacitance components. The changes in the BPF characteristics when mounted onto a PCB could be compensated for by re-designing the BPF, but this would impose serious constraints on a designer. In addition, the re-designed BPF would only compensate for the changes in the BPF characteristics for mounting onto one particular type of PCB. If the re-designed BPF were mounted onto a different PCB, the characteristics of the BPF would again be changed from those required.

The parasitic capacitances introduced by mounting the RF BPF onto a PCB are increased due to the relatively high dielectric constant εᵣ (relative permittivity) of the non-conductive layer of the PCB which are present in the non-conductive regions between the pads, terminals and ground conductors.

Relevant prior art disclosing the features of the preamble of claim 1 includes document JP-A-02 295 183.

The present invention aims to provide a PCB on which an RF BPF may be mounted without significantly changing RF BPF characteristics. The present invention also aims to provide a method of making such a PCB.

According to a first aspect of the present invention there is provided a printed circuit board (PCB) for mounting a radio frequency (RF) band pass filter (BPF) thereon, the filter having an input terminal, an output terminal, and at least one ground terminal, the PCB comprising:
a first pad for mounting the input terminal of the RF BPF thereon;
a second pad for mounting the output terminal of the RF BPF thereon; and
at least one ground pad for mounting the at least one ground terminal of the RF BPF thereon;
characterised: by a plurality of holes formed through the PCB in a thickness direction, said plurality of holes comprising:
a first hole formed through the PCB between the first and at least one ground pad; and
a second hole formed through the PCB between the second and at least one ground pad; wherein
a diameter of each of the first and second holes is equal to or greater than a width of the PCB between said first and at least one ground pad or said second and said at least one ground pad respectively.

According to a second aspect of the present invention there is provided a method of making a PCB for mounting an RF BPF having an input terminal, an output terminal, and a ground conductor with at least one terminal, comprising the steps of:
forming a first pad, a second pad and at least one ground pad on the PCB in locations corresponding to the locations on the corresponding terminals of the RF BPF, for respectively mounting the terminals of the RF BPF thereon; characterised by
forming holes through the PCB in a thickness direction, in at least the following locations:
   a first hole between the first pad and at least one ground pad; and
   a second hole between at least one ground pad and the second pad; wherein
   a diameter of each of the first and second holes is equal to or greater than a width of the PCB between said first and at least one ground pad or said second and said at least one ground pad respectively.

Embodiments of the present invention provide that the dielectric constant of its non-conductive regions has a reduced influence on the characteristics of an RF BPF which may be mounted on the PCB.

Embodiments of the present invention provide that an RF BPF may be mounted thereon with a minimal change in the impedance or the frequency bandwidth of the RF BPF.

Accordingly, a PCB according to the present invention on which an RF BPF may be mounted without changing its characteristics obviates the need for redesigning the BPF to compensate for changes in characteristics of the RF BPF when mounted on a PCB.

The present invention will now be described by way of example with reference to the accompanying drawings in which:
FIGs. 1A and 1B are perspective views respectively illustrating the top and bottom outer structure of an RF BPF, in respect of which the present invention may be applied;
FIG. 2 is a plan view of a conventional PCB on which the RF BPF of FIGs. 1A and 1B may conventionally be mounted;
FIG. 3 is a Smith chart showing the characteristics of an unmounted RF BPF such as that shown in FIGs. 1A and 1B;
FIG. 4 is a Smith chart showing the characteristics of an RF BPF such as that used for FIG. 3, but mounted on a conventional PCB such as that shown in FIG. 2;

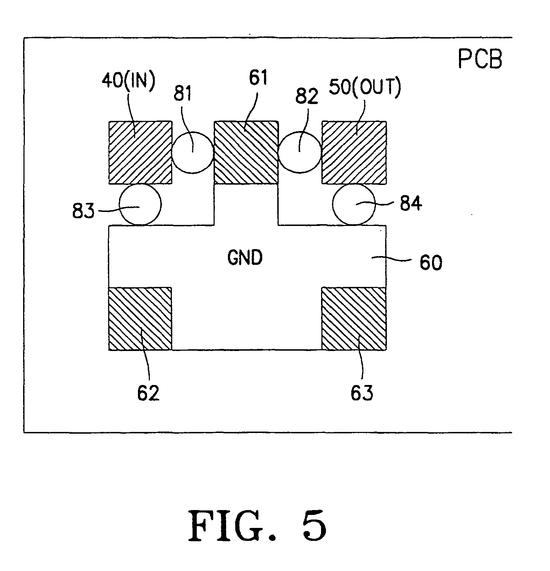

FIG. 5 is a plan view illustrating a PCB according to an embodiment of the present invention, on which the RF BPF of FIGs. 1A and 1B may be mounted; and

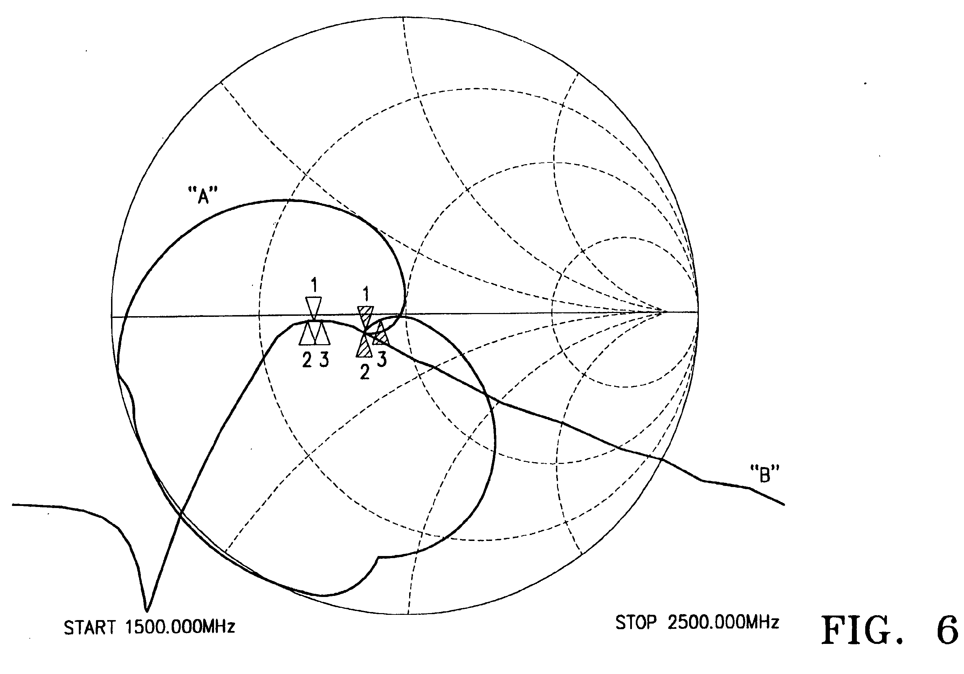

FIG. 6 is a Smith chart showing the characteristics of an RF BPF such as that used for FIGs. 3, 4 and shown in FIGs. 1A and 1B, mounted on the PCB of FIG. 5.

FIG. 5 illustrates a PCB according to an embodiment of the present invention on which an RF BPF such as that shown in FIGs. 1A and 1B may be mounted by soldering.

The PCB has an IN pad 40, an OUT pad 50, and three ground pads 61, 62, 63. The ground pads may be connected together by a ground conductor 60, formed on the surface of the PCB.

The IN terminal 10, the OUT terminal 20 and the ground terminals 31, 32, 33 of the RF BPF are each respectively mounted, such as by soldering, onto the IN pad 40; the OUT pad 50 and the ground pads 61, 62, 63 of the PCB.

As shown in FIG. 5, the various pads 40, 50, 61, 62, 63 and the ground conductor 60 are separated from each other by non-conductive regions of predetermined widths. The predetermined widths are to some extent dictated by the layout of the terminals of the RF BPF. In the embodiment shown in FIG. 5, the IN pad 40 is separated from the ground pad 61, and from a portion of ground conductor 60, by a non-conductive region of a predetermined width. Similarly, the OUT pad 50 is separated from the ground pad 61, and from a portion of ground conductor 60, by a non-conductive region of a predetermined width. The predetermined widths may be the same, or different, for each non-conductive region. Pads 40, 61, 50 are respectively arranged in a line; pads 40, 50, 63, 62 are respectively arranged at the corners of a rectangle Pads 61, 62, 63 are connected together by ground conductor 60, which occupies the rectangle in locations other than the pads or the non-conductive regions of predetermined width.

According to an embodiment of the present invention, the PCB further includes holes 81 to 84 which penetrate through the PCB in a PCB thickness direction. First hole 81 is disposed between the IN pad 40 and the first ground pad 61. The second hole 82 is disposed between the OUT pad 50 and the first ground pad 61. The third hole 83 is disposed between the IN pad 40 and the second ground pad 62. The fourth hole 84 is disposed between the OUT pad 50 the third ground pad 63.

Where a ground conductor 60 is provided, third and fourth holes 83, 84 are preferably disposed between the IN pad 40 and the ground conductor 60; and the OUT pad 50 and the ground conductor 60, respectively.

Here, non-conductive regions of predetermined widths are disposed between the IN pad 40 and each of the first and second ground pads 61 and 62 (and ground conductor 60, if present). Further non-conductive regions of a predetermined width are disposed between the OUT pad 50 and each of the first and third ground pads 61 and 63 (and ground conductor 60, if present).

The diameters of the first to fourth holes 81 to 84 are each equal to or larger than the width of the corresponding non-conductive regions.

The first to fourth holes 81 to 84 serve to remove the non-conductive PCB material from between the IN pad 40 and each of the first and second ground pads 61 and 62; and between the OUT pad 50 and each of the first and third ground pads 61 and 63. This obviates the increase in parasitic capacitance components caused by the high dielectric constant εᵣ of the non-conductive material of the PCB.

The dielectric constant of the non-conductive material of the PCB (er= 4.5) is replaced by that of air (er = 1) between the IN terminal/pad and adjacent ground terminal/pad/conductors; and between the OUT terminal/pad and adjacent ground terminal/pad/conductors. As a result, parasitic capacitance components can be minimised.

FIG. 6 is a Smith chart showing the characteristics of an RF BPF such as that which provided the characteristics shown on FIGs. 3, 4, mounted on a PCB of the invention as shown in FIG. 5.

Comparing FIG. 6 with FIG. 4, the impedance of the BPF returns toward the inductance location as indicated by curve "A" of FIG. 6 and the frequency bandwidth thereof becomes wide as indicated by curve "B" of FIG. 6.

Table 1, below, shows impedance characteristics in three cases: the unmounted RF BPF, the RF BPF mounted on the conventional PCB of FIG. 2; and the RF BPF mounted on the PCB of the present invention as shown in FIG. 5. The measurements are based on the Smith charts shown in FIGs. 3, 4, and 6.

**Table 1**

| | | | |
|---|---|---|---|
| | Unmounted RF BPF | on PCB (conventional) | on PCB (present invention) |
| 1 | 40.803W, 34.3790W | 20.581W, -17.9370W | 39.596W, -3.3867W |
| 2 | 69.008W, 8.2462W | 15.146W, -7.1318W | 38.754W, -4.9453W |
| 3 | 46.410W, -4.4023W | 21.715W, -49.3240W | 42.611W, -1.7773W |

| | | | |
|---|---|---|---|
| Reference numerals 1, 2, and 3 indicate points on curves "A" of FIGs. 3, 4, and 6. | | | |

Table 1 shows that impedance of the RF BPF has much greater capacitance components (-17.9370, -7.1318, and - 49.3240W) when mounted on the conventional PCB. The impedance (-3.3867, -4.9453, and -1.7773W) of the RF BPF when mounted on the PCB of the present invention is nearer to that of the unmounted RF BPF, as compared to the RF BPF mounted on the conventional PCB.

As described above, capacitance components between an input terminal and a ground terminal, and between an output terminal and a ground terminal in an RF BPF such as a dielectric filter are reduced when a PCB of the present invention is used for mounting. The impedance characteristics of the BPF mounted on the PCB of the present invention are approximate to those of the BPF alone. Therefore, additional circuit designing to compensate for changed characteristics of the RF BPF mounted on a PCB is not required when a PCB according to the present invention is used.

While the present invention has been described in detail with reference certain specific embodiments, it is to be clearly understood that many variations and modifications will be apparent to anyone skilled in the art.

For example, the holes formed in the PCB may be drilled, cut or stamped to any desired form. One, or several, holes may be provided in each non-conductive region. It may be advantageous for the holes to replicate the shape of the non-conductive region between the pads concerned. Although described only in relation to single sided PCBs, the invention may simply be applied to double sided or multi-layer PCBs. In the case of multi-layer PCBs, the holes may not penetrate the entire thickness of the PCB, but only the layer containing the pads concerned.

Although only described in relation to capacitive coupling to ground, the method and PCB of the present invention may be applied to reduce parasitic capacitances in any PCB application where capacitive coupling occurs between adjacent conductors, which may be pads or other conductors.

Although described only with reference to RF BPF, the present application may be applied to PCBs which carry any components which are sensitive to parasitic capacitance.

Although described only with reference to holes as low dielectric constant regions, any suitable material of low permittivity may be used.

## Claims

1. A printed circuit board (PCB) for mounting a radio frequency (RF) band pass filter (BPF) thereon, the filter having an input terminal (10), an output terminal (20), and at least one ground terminal (31, 32, 33), the PCB comprising:
a first pad (40) for mounting the input terminal of the RF BPF thereon;
a second pad (50) for mounting the output terminal (20) of the RF BPF thereon; and
at least one ground pad (61) for mounting the at least one ground terminal of the RF BPF thereon;
**characterised by** a plurality of holes formed through the PCB in a thickness direction, said plurality of holes comprising:
a first hole (81) formed through the PCB between the first and at least one ground pad; and
a second hole (82) formed through the PCB between the second and at least one ground pad; wherein
a diameter of each of the first and second holes is equal to or greater than a width of the PCB between said first and at least one ground pad or said second and said at least one ground pad respectively.

2. A printed circuit board according to claim 1 wherein said PCB further comprises:
a fourth pad (62) for mounting a second ground terminal (32) of the RF BPF thereon;
a fifth pad (63) for mounting a third ground terminal (33) of the RF BPF thereon; and wherein said plurality of holes further comprises:
a third hole (83) formed through the PCB between the first and fourth pads; and
a fourth hole (84) formed through the PCB between the second and fifth pads; wherein
a diameter of each of the third and fourth holes is equal to or greater than a width of the PCB between the first and fourth pad or said second and fifth pad respectively.

3. A printed circuit board according to claim 2, further comprising a non-conductive region between the first and third pads; a non-conductive region between the second and third pads; a non-conductive region between the first and fourth pads; and a non-conductive region between the second and fifth pads, the first to fourth holes each being comprised within a respective non-conductive region.

4. A printed circuit board according to claim 3 wherein the holes have widths at least equal to the widths of the corresponding non-conductive regions.

5. A printed circuit board according to claim 4 wherein all the non-conductive regions have a same width, and all the holes have a same width.

6. A printed circuit board according to any of claims 1 to 5 wherein each hole is circular.

7. A method of making a PCB for mounting an RF BPF having an input terminal, an output terminal, and a ground conductor with at least one terminal, comprising the steps of:
forming a first pad, a second pad and at least one ground pad on the PCB in locations corresponding to the locations of the corresponding terminals of the RF BPF, for respectively mounting the terminals of the RF BPF thereon;
**characterised by**
forming holes through the PCB in a thickness direction, in at least the following locations:
a first hole between the first pad and at least one ground pad; and
a second hole between at least one ground pad and the second pad; wherein
a diameter of each of the first and second holes is equal to or greater than a width of the PCB between said first and at least one ground pad or said second and said at least one ground pad respectively.

8. The method according to claim 7 further comprising the steps of:
forming a fourth pad (62) for mounting a second ground terminal (32) of the RF BPF thereon;
forming a fifth pad (63) for mounting a third ground terminal (33) of the RF BPF thereon;
forming a third hole (83) through the PCB between the first and fourth pads; and
forming a fourth hole (84) through the PCB between the second and fifth pads; wherein
a diameter of each of the third and fourth holes is equal to or greater than a width of the PCB between the first and fourth pad or said second and fifth pad respectively.

## Patentansprüche

1. Eine gedruckte Leiterplatte (PCB), um einen Radiofrequenz (RF)-Bandpassfilter (BPF) darauf anzubringen, wobei der Filter einen Eingangsanschluss (10), einen Ausgangsanschluss (20) und mindestens einen Masseanschluss (31, 32, 33) aufweist und wobei die PCB Folgendes umfasst:
ein erstes Lötauge (40), um den Eingangsanschluss des RF-BPF darauf anzubringen;
ein zweites Lötauge (50), um den Ausgangsanschluss (20) des RF-BPF darauf anzubringen;
mindestens ein Masselötauge (61), um mindestens einen Masseanschluss des RF-BPF darauf anzubringen;
**gekennzeichnet durch** eine Mehrheit von Löchern, die in einer Dickerichtung **durch** die PCB ausgebildet sind, wobei die genannte Mehrheit von Löchern Folgendes umfasst:
ein erstes Loch (81), das zwischen dem ersten Lötauge und dem mindestens einen Masselötauge **durch** die PCB ausgebildet ist; und
ein zweites Loch (82), das zwischen dem zweiten Lötauge und dem mindestens einen Masselötauge **durch** die PCB ausgebildet ist; wobei
ein Durchmesser des ersten und des zweiten Lochs jeweils gleich oder größer ist als eine Breite der PCB zwischen dem genannten ersten Lötauge und dem mindestens einen Masselötauge beziehungsweise zwischen dem genannten zweiten Lötauge und dem genannten mindestens einen Masselötauge.

2. Eine gedruckte Leiterplatte nach Anspruch 1, wobei die PCB weiter Folgendes umfasst:
ein viertes Lötauge (62), um den zweiten Masseanschluss (32) des RF-BPF darauf anzubringen;
ein fünftes Lötauge (63, um den dritten Masseanschluss (33) des RF-BPF darauf anzubringen; und wobei die genannte Mehrheit von Löchern weiter Folgendes umfasst:
ein drittes Loch (83), das zwischen dem ersten und dem vierten Lötauge durch die PCB ausgebildet ist; und
ein viertes Loch (84), das zwischen dem zweiten und dem fünften Lötauge durch die PCB ausgebildet ist; wobei
ein Durchmesser des dritten und des vierten Lochs jeweils gleich groß oder größer ist als eine Breite der PCB zwischen dem ersten und dem vierten Lötauge beziehungsweise zwischen dem genannten zweiten und dem fünften Lötauge.

3. Eine gedruckte Leiterplatte nach Anspruch 2, weiter umfassend eine nicht leitende Region zwischen dem ersten und dem dritten Lötauge; eine nicht leitende Region zwischen zweiten und dem dritten Lötauge; eine nicht leitende Region zwischen dem ersten und dem vierten Lötauge und eine nicht leitende Region zwischen dem zweiten und dem fünften Lötauge, wobei das erste bis vierte Lötauge jeweils innerhalb einer jeweiligen nicht leitenden Region enthalten sind.

4. Eine gedruckte Leiterplatte nach Anspruch 3, wobei die Löcher Breiten haben, die mindestens gleich den Breiten der entsprechenden nicht leitenden Regionen sind.

5. Eine gedruckte Leiterplatte nach Anspruch 4, wobei die nicht leitenden Regionen alle die selbe Breite haben und die Löcher alle die selbe Breite haben.

6. Eine gedruckte Leiterplatte nach einem der Ansprüche 1 bis 5, wobei die Löcher jeweils kreisförmig sind.

7. Ein Verfahren zum Herstellen einer PCB zum Anbringen eines RP-BPF mit einem Eingangsanschluss, einem Ausgangsanschluss und einem Masseleiter mit mindestens einem Anschluss, das folgende Schritte umfasst:
Bilden eines ersten Lötauges, eines zweiten Lötauges und mindestens eines Masselötauges auf der PCB an Orten, die den Orten der entsprechenden Anschlüsse des RF-BPF entsprechen, um jeweils die Anschlüsse des RF-BPF darauf anzubringen; **gekennzeichnet durch**:
Bilden von Löchern **durch** die PCB in einer Dickerichtung an mindestens den folgenden Orten:
ein erstes Loch zwischen dem ersten Lötauge und dem mindestens einen Masselötauge; und
ein zweites Loch zwischen dem mindestens einen Masselötauge und dem zweiten Lötauge; wobei
jeweils ein Durchmesser des ersten und des zweiten Lochs gleich oder größer ist als eine Breite der PCB zwischen dem genannten ersten Lötauge und dem mindestens einen Masselötauge beziehungsweise zwischen dem genannten zweiten Lötauge und dem genannten mindestens einen Masselötauge.

8. Das Verfahren nach Anspruch 7, das weiter die folgenden Schritte umfasst:
Bilden eines vierten Lötauges (62), um einen zweiten Masseanschluss (32) des RF-BPF darauf anzubringen;
Bilden eines fünften Lötauges (63), um einen dritten Masseanschluss (33) des RF-BPF darauf anzubringen;
Bilden eines dritten Lochs (83) zwischen dem ersten und dem vierten Lötauge durch die PCB; und
Bilden eines vierten Lochs (84) zwischen dem zweiten und dem fünften Lötauge durch die PCB; wobei
ein Durchmesser des dritten und des vierten Lochs jeweils gleich groß oder größer ist als eine Breite der PCB zwischen dem ersten und dem vierten Lötauge beziehungsweise zwischen dem genannten zweiten und dem fünften Lötauge.

## Revendications

1. Carte à circuits imprimés servant de support de montage à un filtre passe-bande de radiofréquences, qui est monté sur celle-ci, le filtre possédant une borne d'entrée (10), une borne de sortie (20) et au moins une borne de terre (31, 32, 33), la carte à circuits imprimés comprenant :
une première plage d'accueil (40) servant de support de montage et permettant d'y monter la borne d'entrée du filtre passe-bande de radiofréquences ;
une deuxième plage d'accueil (50) servant de support de montage et permettant d'y monter la borne de sortie (20) du filtre passe-bande de radiofréquences ; et
au moins une plage d'accueil de terre (61) servant de support de montage et permettant d'y monter la au moins une borne de terre du filtre passe-bande de radiofréquences ;
**caractérisé par** une pluralité de trous qui sont formés à travers la carte à circuits imprimés suivant un sens d'épaisseur, ladite pluralité de trous comprenant :
un premier trou (81) lequel est formé à travers la carte à circuits imprimés entre la première plage d'accueil et au moins une plage d'accueil de terre ; et
un deuxième trou (82) lequel est formé à travers la carte à circuits imprimés entre la deuxième plage d'accueil et au moins une plage d'accueil de terre ; cas dans lequel
un diamètre de chacun des premier et deuxième trous est égal ou supérieur à une largeur de la carte à circuits imprimés entre ladite première plage d'accueil et au moins une plage d'accueil de terre ou bien ladite deuxième plage d'accueil et ladite au moins une plage d'accueil de terre respectivement.

2. Carte à circuits imprimés, selon la revendication 1, dans laquelle ladite carte à circuits imprimés comprend en outre :
une quatrième plage d'accueil (62) servant de support de montage et permettant d'y monter une deuxième borne de terre (32) du filtre passe-bande de radiofréquences ;
une cinquième plage d'accueil (63) servant de support de montage et permettant d'y monter une troisième borne de terre (33) du filtre passe-bande de radiofréquences ; et dans laquelle ladite pluralité de trous comprend en outre :
un troisième trou (83) lequel est formé à travers la carte à circuits imprimés entre la première et la quatrième plages d'accueil ; et
un quatrième trou (84) lequel est formé à travers la carte à circuits imprimés entre la deuxième et la cinquième plages d'accueil ; cas dans lequel
un diamètre de chacun des troisième et quatrième trous est égal ou supérieur à une largeur de la carte à circuits imprimés entre la première et la quatrième plages d'accueil ou bien lesdites deuxième et cinquième plages d'accueil respectivement.

3. Carte à circuits imprimés, selon la revendication 2, comprenant en outre une région non-conductrice entre la première et la troisième plages d'accueil ; une région non-conductrice entre la deuxième et la troisième plages d'accueil ; une région non-conductrice entre la première et la quatrième plages d'accueil ; et une région non-conductrice entre la deuxième et la cinquième plages d'accueil, alors que les premier au quatrième trous sont chacun compris à l'intérieur d'une région non-conductrice respective.

4. Carte à circuits imprimés, selon la revendication 3, dans laquelle les trous ont des largeurs qui sont au moins égales aux largeurs des régions non-conductrices correspondantes.

5. Carte à circuits imprimés, selon la revendication 4, dans laquelle toutes les régions non-conductrices ont une même largeur, et tous les trous ont une même largeur.

6. Carte à circuits imprimés, selon l'une quelconque des revendications 1 à 5, dans laquelle chaque trou est circulaire.

7. Procédé permettant de fabriquer une carte à circuits imprimés destinée à servir de support de montage à un filtre passe-bande de radiofréquences ayant une borne d'entrée, une borne de sortie et un conducteur de terre pourvu au moins d'une borne, comprenant les étapes suivantes :
former une première plage d'accueil, une deuxième plage d'accueil et au moins une plage d'accueil de terre sur la carte à circuits imprimés dans des emplacements correspondant aux emplacements des bornes correspondantes du filtre passe-bande de radiofréquences, afin de permettre d'y monter respectivement les bornes du filtre passe-bande de radiofréquences ; **caractérisé par**
la formation de trous à travers la carte à circuits imprimés suivant un sens d'épaisseur, dans les emplacements suivants au moins :
un premier trou entre la première plage d'accueil et au moins une plage d'accueil de terre ; et
un deuxième trou entre au moins une plage d'accueil de terre et la deuxième plage d'accueil ; cas dans lequel
un diamètre de chacun des premier et deuxième trous est égal ou supérieur à une largeur de la carte à circuits imprimés entre ladite première plage d'accueil et au moins une plage d'accueil de terre ou bien ladite deuxième plage d'accueil et ladite au moins une plage d'accueil de terre respectivement.

8. Procédé, selon la revendication 7, comprenant en outre les étapes suivantes :
former une quatrième plage d'accueil (62) servant de support de montage et permettant d'y monter une deuxième borne de terre (32) du filtre passe-bande de radiofréquences ;
former une cinquième plage d'accueil (63) servant de support de montage et permettant d'y monter une troisième borne de terre (33) du filtre passe-bande de radiofréquences ;
former un troisième trou (83) à travers la carte à circuits imprimés entre la première et la quatrième plages d'accueil ; et
former un quatrième trou (84) à travers la carte à circuits imprimés entre la deuxième et la cinquième plages d'accueil ; cas dans lequel
un diamètre de chacun des troisième et quatrième trous est égal ou supérieur à une largeur de la carte à circuits imprimés entre la première et la quatrième plages d'accueil ou bien ladite deuxième et cinquième plages d'accueil respectivement.
